Europäisches Patentamt

European Patent Office

Office européen des brevets

(19)

(11) Veröffentlichungsnummer: **0 082 422**

**A1**

(12) **EUROPÄISCHE PATENTANMELDUNG**

(21) Anmeldenummer: **82111404.8**

(22) Anmeldetag: **09.12.82**

(51) Int. Cl.³: **H 03 K 17/687**

(30) Priorität: **23.12.81 AT 5530/81**

(43) Veröffentlichungstag der Anmeldung:
**29.06.83 Patentblatt 83/26**

(84) Benannte Vertragsstaaten:
**AT CH DE FR IT LI**

(71) Anmelder: **SIEMENS AKTIENGESELLSCHAFT
Berlin und München Wittelsbacherplatz 2
D-8000 München 2(DE)**

(72) Erfinder: **Almeder, Ernst
Mayerweckstrasse 6
A-1210 Wien(AT)**

(72) Erfinder: **Cyba, Edward Michael
Czerningasse 16/3/13
A-1020 Wien(AT)**

(72) Erfinder: **Ramlohr, Franz
Heckenweg 7
A-1222 Wien(AT)**

(54) Beschaltung für einen Leistungs-Feldeffekttransistor.

(57) Bei der erfindungsgemäßen Beschaltung für einen eine induktive Last (L) schaltenden, über einen Ansteuer-Widerstand (4) gesteuerten Leistungs-Feldeffekttransistor (1) ist der Gate-Drain-Strecke des Leistungs-Feldeffekttransistors (1) ein Kondensator (2) parallel geschaltet, wobei die Zeitkonstante des aus Ansteuer-Widerstand (4) und Kondensator (2) gebildeten RC-Glieds die für die Schaltungsanordnung zulässige Spannungs-Anstiegsgeschwindigkeit bestimmt. Damit wird eine definierte Schaltzeitverlängerung durch Eingriff in den Steuerkreis erreicht und die Schaltgeschwindigkeit wird nahezu ausschießlich durch die Zeitkonstante von Ansteuer-Widerstand (4) und Kondensator (2) bestimmt und ist beispielsweise von der zu schaltenden Last (L) und von üblichen Exemplarstreuungen des Leistungs-Feldeffekttransistors (1) weitgehend unabhängig.

FIG 1

EP 0 082 422 A1

SIEMENS AKTIENGESELLSCHAFT

Schö/Gl

Wien, 23.12.81

VPA 81 P 9633

## Beschaltung für einen Leistungs-Feldeffekttransistor

Die Erfindung betrifft eine Beschaltung für einen eine
induktive Last schaltenden, über einen Ansteuer-Widerstand
gesteuerten Leistungs-Feldeffekttransistor.

Für Schaltaufgaben im Leistungsbereich werden zunehmend
Leistungs-Feldeffekttransistoren eingesetzt. Diese haben
den Vorteil, daß sie mit sehr geringer Ansteuerleistung
auskommen, so daß der Ansteuerkreis vereinfacht werden
kann und der Wirkungsgrad verbessert wird. Außerdem sind
die Schaltzeiten bei Leistungs-Feldeffekttransistoren im
Vergleich zu bipolaren Transistoren kürzer, so daß die
Schaltfrequenzen erhöht werden können. Dadurch kommt man
mit kleineren magnetischen Bauteilen und kleineren Kapazitäten aus. Andererseits wird die Spannungs-Anstiegsgeschwindigkeit beim Ausschalten von Leistungs-Feldeffekttransistoren so hoch, daß damit u.U. Bauelemente im Schaltkreis gefährdet werden können. Man könnte zwar daran
denken, gefährdete Bauelemente durch herkömmliche RCD-Beschaltungen zu schützen. Dies wäre jedoch mit einem verhältnismäßig hohen Aufwand verbunden, da diese Beschaltungen im Leistungskreis angeordnet werden müßten.

- 2 -

Aufgabe der Erfindung ist es daher, bei einem Leistungs-Feldeffekttransistor eine definierte Schaltzeitverlängerung durch Eingriff in den Steuerkreis zu erreichen.

Diese Aufgabe wird erfindungsgemäß dadurch gelöst, daß der Gate-Drain-Strecke des Leistungs-Feldeffekttransistors ein Kondensator parallel geschaltet ist, wobei die Zeitkonstante des aus Ansteuer-Widerstand und Kondensator gebildeten RC-Glieds an die für die Schaltungsanordnung zulässige Spannungs-Anstiegsgeschwindigkeit angepaßt ist.

Durch die mit dem Kondensator erreichte Gegenkopplung vom Lastkreis in den Steuerkreis des Leistungs-Feldeffekttransistors kann die Schaltgeschwindigkeit und damit die Spannungs-Anstiegsgeschwindigkeit auf ein gewünschtes Maß reduziert werden. Die Schaltgeschwindigkeit wird nahezu ausschließlich durch die Zeitkonstante von Ansteuer-Widerstand und Kondensator bestimmt und ist beispielsweise von der zu schaltenden Last und von üblichen Exemplarstreuungen des Leistungs-Feldeffekttransistors weitgehend unabhängig. Die Verringerung der Spannungs-Anstiegsgeschwindigkeit wird mit einem einzigen Kondensator und damit mit sehr geringem Aufwand erzielt.

In Serie zum Kondensator kann ein Widerstand geschaltet sein. Dieser Widerstand verhindert eine Schwingungsneigung der Schaltungsanordnung, falls diese aufgrund von Induktivitäten in der Leitungsführung auftreten sollte.

In Serie zum Kondensator kann ein Verstärker geschaltet sein. Da mit diesem Verstärker der Gegenkopplungsgrad erhöht werden kann, kommt man mit einem kleineren Kondensator aus.

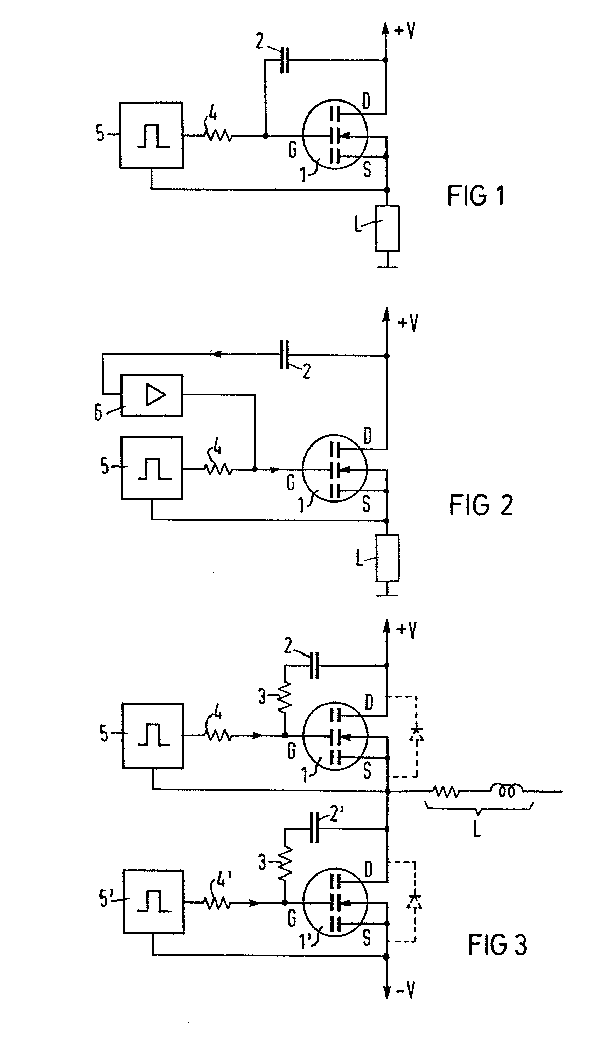

Ein Ausführungsbeispiel der Erfindung wird nachfolgend anhand der Figuren 1 bis 3 näher erläutert.

Figur 1 zeigt einen Leistungs-Feldeffekttransistor 1,
dessen Drain D mit dem Pluspol +V einer Versorgungsspannungsquelle und dessen Source mit einer beliebigen zu
schaltenden Last L verbunden ist. Der Leistungs-Feldeffekttransistor 1 wird mit einer Ansteuereinrichtung 5 angesteuert, deren Bezugspunkt mit dem Source-Anschluß des
Leistungs-Feldeffekttransistors 1 verbunden ist. Die Ansteuerimpulse der Ansteuereinrichtung 5 werden über einen
Widerstand 4 dem Gate G des Leistungs-Feldeffekt-Transistors 1 zugeführt. Parallel zur Drain-Gate-Strecke des
Leistungs-Feldeffekttransistors 1 liegt ein Kondensator 2.


Wenn der Leistungs-Feldeffekttransistor 1 ausgeschaltet
werden soll, so geht der Ansteuerimpuls auf Null. Ohne
den Kondensator 2 würde die Gate-Source-Spannung unverzögert ebenfalls auf Null gehen und damit den Leistungs-
Feldeffekttransistor 1 sehr schnell ausschalten. Dies
führt zu einem schnellen Abreißen des den Leistungs-Feldeffekttransistor 1 durchfließenden Stroms und zu einem
schnellen Spannungs-Anstieg am Leistungs-Feldeffekttransistors 1. Die an induktiven Bauelementen des Lastkreises
auftretenden Spannungsspitzen können dadurch sehr große
Werte erreichen und im Extremfall zu einer Zerstörung
spannungsempfindlicher Bauteile führen. Der Ausschaltvorgang wird daher mit dem Kondensator 2 verlangsamt. Wenn
nämlich bei Unterschreiten der Schwellspannung der Gate-
Source-Strecke des Leistungs-Feldeffekttransistors 1
dieser zu sperren beginnt, so steigt die Source-Drain-
Spannung an. Dieser Spannungs-Anstieg wird über den
Kondensator 2                       auf das Gate des
Leistungs-Feldeffekttransistors zurückgekoppelt, so daß
die Gate-Source-Spannung wieder angehoben wird. Es liegt
also eine Gegenkopplung vom Leistungskreis in den Steuerkreis des Leistungs-Feldeffekttransistors 1 vor, die den
Spannungs-Anstieg an der Drain-Source-Strecke des Leistungs-Feldeffekttransistors 1 verzögert, bis der
Kondensator 2 über den Widerstand 4 nahezu auf die Versorgungsspannung +V aufgeladen ist. Die Verzögerungszeit
ist dabei praktisch nur von der Zeitkonstante des aus dem
Kondensator 2 und dem Widerstand 4 bestehenden RC-Glieds
abhängig.

Von besonderem Vorteil ist, daß die Spannungs-Anstiegsgeschwindigkeit weitgehend unabhängig von der Last L und den
Parametern des Leistungs-Feldeffekttransistors 1 wird.
Würde man beispielsweise eine Abflachung des Einschaltimpulses durch eine RC-Beschaltung im Gate-Source-Kreis
des Leistungs-Feldeffekttransistors 1 vorsehen, so wäre
die Schaltzeit des Leistungs-Feldeffekttransistors 1 von
der Last und von der üblicherweise stark streuenden Gate-
Drain-Kapazität des Leistungs-Feldeffekttransistors 1
abhängig.

Die Kapazität des erforderlichen Kondensators 2 kann verkleinert werden, wenn man gemäß einem Ausführungsbeispiel
nach Figur 2 dem Kondensator 2 einen Verstärker 6 in Reihe
schaltet. Mit dem Verstärker 6 wird der Gegenkopplungsgrad erhöht, so daß man die Kapazität des Kondensators 2
umgekehrt proportional zur Verstärkung des Verstärkers 6
wählen kann. Wenn das zu verarbeitende Spannungs-Potential
sehr hoch wird, so kann die Serienschaltung eines Verstärkers u.U. kostengünstiger sein als die Verwendung
eines größeren Kondensators mit hoher zulässiger Betriebsspannung.

Mit der beschriebenen Schaltung wird nicht nur der Ausschaltvorgang, sondern auch der Einschaltvorgang des
Leistungs-Feldeffekttransistors 1 verzögert. Wenn die
Ansteuerschaltung 5 einen positiven Ansteuerimpuls abgibt,

Neue Beschreibungsseiten 5, 5a          Unser Zeichen
                                         VPA 81 P 9633 E
                                         Anmeldung Nummer
                                         82 11 1404.8

- 5 -

so beginnt der Leistungs-Feldeffekttransistor 1 zu leiten,
sobald die Gate-Source-Spannung ihren Schwellwert überschreitet. Damit beginnt die Drain-Source-Spannung am
Leistungs-Feldeffekttransistor 1 zusammenzubrechen. Der
während der Sperrphase nahezu auf die volle Versorgungsspannung +V aufgeladene Kondensator 2 verringert jedoch
dann die Gate-Source-Spannung, so daß der Einschaltvorgang ebenfalls verzögert wird. Dabei ist wie beim Ausschaltvorgang ebenfalls die Zeitkonstante des aus dem
Kondensator 2 und dem Widerstand 4 bestehenden RC-Glieds
maßgebend.

Die beschriebene Beschaltung kann beispielsweise vorteilhaft für Transistor-Gleichstromsteller eingesetzt werden.
Figur 3 zeigt eine Brückenhälfte eines derartigen Gleichstromstellers, bestehend aus zwei Brückenzweigen mit jeweils einem Leistungs-Feldeffekttransistor 1 bzw. 1'. Am
Verbindungspunkt der beiden Leistungs-Feldeffekttransistoren 1 und 1' ist eine durch eine Reihenschaltung vom
Widerstand und Induktivität dargestellte Last L angeschlossen. Dabei erübrigt sich eine besondere Freilaufdiode, da Leistungs-Feldeffekttransistoren stets eine in
Figur 3 gestrichelt eingezeichnete Dioden-Funktion zwischen Source und Drain enthalten. Diese auch als "Body-
Drain-Diode" bezeichnete Dioden-Funktion weist eine Leitrichtung vom Source-Anschluß zum Drain-Anschluß des
Leistungs-Feldeffekttransistors auf und kann somit einen
Rückspeisestrom des Gleichstromstellers übernehmen. Alle
Leistungs-Feldeffekttransistoren der Brückenscchaltung
weisen die beschriebene Beschaltung mit einem Kondensator
und einen in Reihe geschalteten Widerstand 3 parallel zur

Soe 2 Bim / 24.02.1983

- 6 -       VPA 81 P 9633 E

Gate-Drain-Strecke des Leistungs-Feldeffekttransistors 1 bzw. 1' auf, so daß die gesamte Schaltung gegen unzulässig hohen Spannungs-Anstieg geschützt wird. Die Widerstände 3 dienen lediglich dazu, eine eventuelle Schwingungsneigung der Schaltungsanordnung aufgrund parasitärer Impedanzen zu verhindern. Die Widerstände 3 weisen daher kleine Werte auf und sind für die Bestimmung der Zeitkonstanten zu vernachlässigen.

Patentansprüche

1. Beschaltung für einen eine induktive Last schaltenden, über einen Ansteuer-Widerstand gesteuerten Leistungs-Feldeffekttransistor, d a d u r c h  g e k e n n - z e i c h n e t ,  daß der Gate-Drain-Strecke des Leistungs-Feldeffekttransistors (1) ein Kondensator (2) parallel geschaltet ist, wobei die Zeitkonstante des aus Ansteuer-Widerstand (4) und Kondensator (2) gebildeten RC-Glieds  die für die Schaltungsanordnung zulässige Spannungs-Anstiegsgeschwindigkeit bestimmt.

2. Beschaltung nach Anspruch 1,  d a d u r c h  g e - k e n n z e i c h n e t ,  daß in Serie zum Kondensator (2) ein Widerstand (3) geschaltet ist.

3. Beschaltung nach Anspruch 1  d a d u r c h  g e k e n n z e i c h n e t ,  daß in Serie zum Kondensator (2) ein Verstärker (6) geschaltet ist.

FIG 1

FIG 2

FIG 3

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | --- | | H 03 K 17/687 |
| Y | GB-A-2 032 719 (WARD & GOLDSTONE LTD.) * Seite 1, Zeilen 71-84; Seite 1, Zeile 126 - Seite 2, Zeile 42; Figuren 1, 2 * | 1 | |
| Y | EDN, Band 26, Nr. 1, Mai 1981 Boston, USA S. CLEMENTE et al. "Careful gate-driver design upspower-MOSFET performance" Seiten 177-182 * Seite 178, linke Spalte, Zeile 38 - Seite 179, linke Spalte, Zeile 18; Figur 1; Seite 182, rechte Spalte, Zeilen 5-10 * | 1 | |
| A | ELEKTRONIK, Band 29, Nr. 8, April 1980, München J. KRAUSSE et al. "Mikrocomputer- und LSI-kompat ible Leistungsschalter" Seiten 61-64 * Abschnitt 3.4; Figuren 6, 7 * | | |
| P,A | ELEKTRONIK, Nr. 11, Juni 1982 B. PELLY "Die Gateladung von Leistungs-MOSFETs" Seiten 91-94 | | |
| A | DE-A-2 914 909 (TSCHELJABINSKIJ POLITECHNITSCHESKIJ INSTITUT IMENI LENINSKOGO KOMSOMOLA) | | |

--- -/-

| RECHERCHIERTE SACHGEBIETE (Int. Cl ³) |
|---|
| H 03 K 17/08 |
| H 03 K 17/16 |
| H 03 K 17/284 |
| H 03 K 17/687 |
| H 03 K 17/693 |
| H 03 K 17/64 |

Der vorliegende Recherchenbericht wurde für alle Patentansprüche erstellt.

| Recherchenort BERLIN | Abschlußdatum der Recherche 07-02-1973 | Prüfer ARENDT M |
|---|---|---|

**EUROPÄISCHER RECHERCHENBERICHT**

**0082422**

Nummer der Anmeldung

EP 82 11 1404

| | EINSCHLÄGIGE DOKUMENTE | | | Seite 2 |
|---|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) | |
| A | GB-A-2 061 571 (RANK ORGANISATION LTD.) * Figur; Seite 2, Zeilen 70 - 108 * | | | |
| | ----- | | | |
| | | | **RECHERCHIERTE SACHGEBIETE (Int. Cl. ³)** | |
| | Der vorliegende Recherchenbericht wurde für alle Patentansprüche erstellt. | | | |

| Recherchenort | Abschlußdatum der Recherche | Prüfer |
|---|---|---|
| BERLIN | 07-02-1973 | ARENDT M |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument